# EUROPEAN PATENT APPLICATION

(11) **EP 2 515 349 A1**
(43) Date of publication of application: **24.10.2012**
(21) Application number: 11003241.4
(22) Date of filing: 18.04.2011
(51) Int. Cl.: H01L 31/048, H01L 31/18, H01L 31/0693

(54) **III-V solar cell package and method of fabricating the same**

(71) Applicant: Everphoton Energy Corporation, Taipei 11493 (TW)
(72) Inventor: Chen, Yee-Lee, Taipei City 104 (TW); Huang, Yu-Pei, Tainan City 701 (TW); Yang, Wen-Bin, Taipei City 114 (TW); Wu, Pei-Hsuan, Kaohsiung City 830 (TW)
(74) Representative: Manitz, Finsterwald & Partner GbR

(57) **Abstract**

A method of fabricating a III-V solar cell package includes providing a solar cell having a first side and an opposite second side, forming a first insulating layer on the first side of the solar cell, forming a second insulating layer on the second side of the solar cell, forming a light-transmitting layer on the first insulating layer, forming a protection layer on the second insulating layer, and laminating the light-transmitting layer and the protection layer so as to attach the first insulating layer to the light-transmitting layer and the solar cell and to attach the second insulating layer to the protection layer and the solar cell, thereby forming a flexible solar cell package since the insulating layers, the light-transmitting layer and the protection layer are all flexible.

## Description

### BACKGROUND OF THE INVENTION

### 1. Field of the Invention

The present invention relates to solar cell packages and, more particularly, to a solar cell package having an embedded solar cell and a method OF fabricating the same.

### 2. Description of Related Art

Solar cells are generally packaged, such that the solar cells and associated bonding wires are protected from erosion by moisture, dust, compounds and the like, and the solar cells may have increased conversion efficiency and prolonged usage time. As an active surface of a solar cell is struck by light, electrons are released to generate an electric current, thereby converting solar energy into electric energy. Accordingly, the encapsulant for encapsulating the solar cell has to have a high light transmittance for facilitating light to pass therethrough.

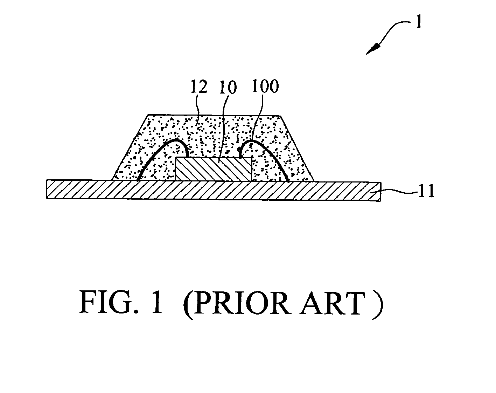

FIG 1 is a schematic view of a conventional solar cell package 1. In fabrication of the solar cell package 1, a solar cell 10 is disposed on a substrate 11 and electrically connected to the substrate 11 through a plurality of bonding wires 100. Then, an encapsulant 12 made of, for example, epoxy resin is formed on the substrate 11. Air bubbles in the encapuslant 12 are removed by means of ultraviolet, infrared or vacuum processes, and the encapsulant 12 is cured, to complete the packaging process.

However, the use of the substrate 11 increases the weight and thickness of the overall structure of the solar cell package 1. Further, since the substrate 11 is hard and non-flexible, the solar cell package 1 cannot meet the low-profiled and compact-sized requirements, and cannot be applied in arc-shaped products but planar products only.

After a long term of use, the surface of the encapsulant 12 is easily to turn yellow, which adversely affects the light transmittance and accordingly reduces the conversion efficiency of the solar cell 10.

Therefore, there is a need to provide a solar cell package and a fabrication method thereof so as to overcome the above-described drawbacks.

### SUMMARY OF THE INVENTION

Accordingly, an object of the present invention is to provide a flexible solar cell package and a method of fabricating the same.

Another object of the present invention is to provide a thin solar cell package and a method of fabricating the same.

In order to achieve the above and other objects, the present invention provides a method of fabricating a III-V solar cell package, which comprises: providing a substrate having a sacrificial layer formed thereon; forming an active layer unit on the sacrificial layer, wherein the active layer unit is made of a III-V compound and has a first surface attached to the sacrificial layer and a second surface opposite to the first surface, the second surface further having a backing layer formed thereon; removing the substrate; removing the sacrificial layer to expose the first surface of the active layer unit; forming a plurality of electrodes on the first surface of the active layer unit and forming a carrier on the backing layer, thereby forming a solar cell having a first side and a second side opposite to the first side; forming a first insulating layer on the first side of the solar cell and forming a second insulating layer on the second side of the solar cell; forming a light-transmitting layer on the first insulating layer and forming a protection layer on the second insulating layer such that the first insulating layer is sandwiched between the solar cell and the light-transmitting layer and the second insulating layer is sandwiched between the solar cell and the protection layer; and heating and laminating the light-transmitting layer and the protection layer in a vacuum environment so as to attach the first insulating layer to the light-transmitting layer and the solar cell and to attach the second insulating layer to the protection layer and the solar cell.

In an embodiment of the present invention, before the first and second insulating layers are formed, the method may further comprise forming a plurality of solar cells and electrically connecting the solar cells in series or in parallel.

In an embodiment of the present invention, after the sacrificial layer is removed and before the electrodes are formed, the method may further comprise forming a carrier on the backing layer.

In an embodiment of the present invention, the light-transmitting layer may be made of a flexible material such as fluorinated ethylene propylene (FEP), or a non-flexible material such as glass.

In an embodiment of the present invention, the first and second insulating layers may be made of, but not limited to, ethylene-vinyl acetate (EVA) or an epoxy material.

The present invention further provides a III-V solar cell package, which comprises: a solar cell having a first side and a second side opposite to the first side, wherein the solar cell comprises an active layer unit made of a III-V compound and having a first surface and a second surface opposite to the first surface, a plurality of electrodes formed on the first surface of the active layer unit, and a backing layer formed on the second surface of the active layer unit; a first insulating layer formed on the first side of the solar cell; a second insulating layer formed on the second side of the solar cell; a light-transmitting layer formed on the first insulating layer such that the first insulating layer is sandwiched between the solar cell and the light-transmitting layer; and a protection layer disposed on the second insulating layer such that the second insulating layer is sandwiched between the solar cell and the protection layer.

In an embodiment of the present invention, the package may further be made of a plurality of solar cells electrically connected in series or in parallel.

In another embodiment of the present invention, the solar cell may further comprise a carrier disposed on the backing layer such that the backing layer is sandwiched between the active layer unit and the carrier.

In an embodiment of the present invention, the light-transmitting layer may comprise a flexible material such as FEP, or a non-flexible material such as glass.

In an embodiment of the present invention, the protection layer may comprise a light-transmitting material, such as poly vinyl fluoride (PVF) or glass, or a light-reflecting material such as Tedlar/Polyester/Tedlar (TPT).

Therefore, by laminating an insulating layer and a light-transmitting layer as well as an insulating layer and a protection layer on two opposite sides of a solar cell, respectively, the present invention obtains a flexible solar cell package since the insulating layers, the light-transmitting layer and the protection layer are all flexible.

Further, both the insulating layer and the light-transmitting layer have high transparency and may keep a normal light transmittance after a long term of use, thus allowing the solar cell to maintain a normal conversion efficiency.

Furthermore, the present invention eliminates the need of a substrate as in the prior art so as to effectively reduce the weight and thickness of the overall structure, thereby achieving the purpose of thinning.

### BRIEF DESCRIPTION OF DRAWINGS

FIG 1 is a cross-sectional view of a conventional solar cell package;
FIGs. 2A to 2C are cross-sectional views illustrating a method of fabricating a III-V solar cell package according to the present invention, wherein FIG. 2A' shows another embodiment of FIG. 2A; and
FIGs. 3A to 3E are cross-sectional views illustrating a process of fabricating a solar cell according to the present invention.

### DETAILED DESCRIPTION OF PREFERRED EMBODIMENTS

The following illustrative embodiments are provided to illustrate the disclosure of the present invention, these and other advantages and effects can be apparent to those in the art after reading this specification.

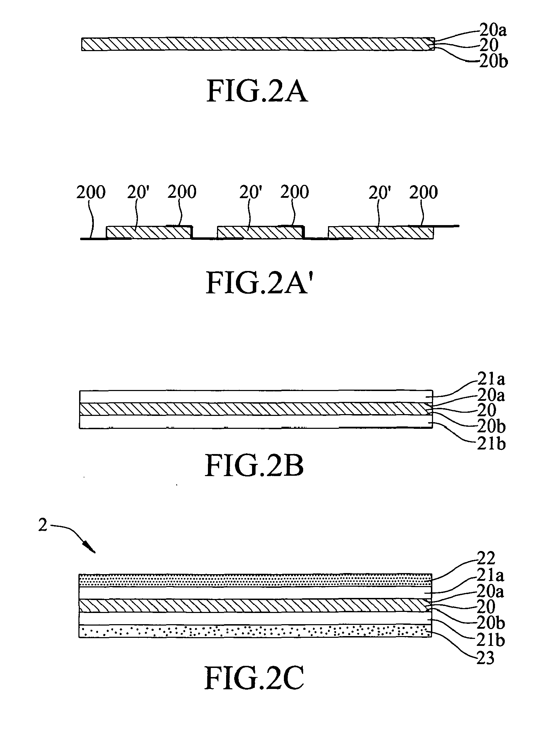

FIGS. 2A to 2C are cross-sectional views illustrating a method of fabricating a III-V solar cell package 2 of an embodiment according to the present invention.

Referring to FIG 2A, a solar cell 20 having a first side 20a and a second side 20b opposite to the first side 20a is provided. In another embodiment, a plurality of solar cells 20' are provided and electrically connected in series through, for example, bonding wires 200, as shown in FIG. 2A'. Alternatively, the solar cells 20' may be electrically connected in parallel (not shown).

Referring to FIG 2B, a first insulating layer 21a and a second insulating layer 21b are formed on the first side 20a and the second side 20b of the solar cell 20, respectively. The first and second insulating layers 21a and 21b are made of ethylene-vinyl acetate (EVA), which has high transparency so as to increase light absorption and current flow.

Referring to FIG 2C, a light-transmitting layer 22 such as a fluorinated ethylene propylene (FEP, commonly known as Teflon) is formed on the first insulating layer 21a, such that the first insulating layer 21 a is sandwiched between the solar cell 20 and the FEP layer 22. Further, a protection layer 23 such as a Tedlar/Polyester/Tedlar (TPT) layer is formed on the second insulating layer 21b, such that the second insulating layer 21b is sandwiched between the solar cell 20 and the TPT layer 23. The TPT layer 23 is commonly referred to as backsheet.

In a vacuum environment, a pressurizing and heating process is performed, to laminate the FEP layer 22 and the TPT layer 23 on the first and second sides 20a and 20b of the solar cell 20, respectively, thereby attaching the first insulating layer 21a to the FEP layer 22 and the solar cell 20 and attaching the second insulating layer 21b to the TPT layer 23 and the solar cell 20.

Therefore, by laminating the first insulating layer 21a and the FEP layer 22 as well as the second insulating layer 21b and the TPT layer 23 on the two sides of the solar cell 20, the present invention obtains a flexible solar cell package 2, since the EVA layers 21a and 21b, the FEP layer 22 and the TPT layer 23 are all flexible. Therefore, the solar cell package 2 can be applied in planar products and in arc-shaped products as well.

Further, since the EVA layers 21a and 21b and the FEP layer 22 have high transparency and do not turn yellow after a long term of use, they keep a normal light transmittance to thereby allow the solar cell 20 to maintain a normal conversion efficiency.

Furthermore, the present invention eliminates the need of a substrate as in the prior art so as to effectively reduce the weight and thickness of the overall structure, thereby achieving the purpose of thinning.

In addition, the present invention reduces the material cost and fabrication cost by laminating thin-film structures on the two sides of the solar cell 20.

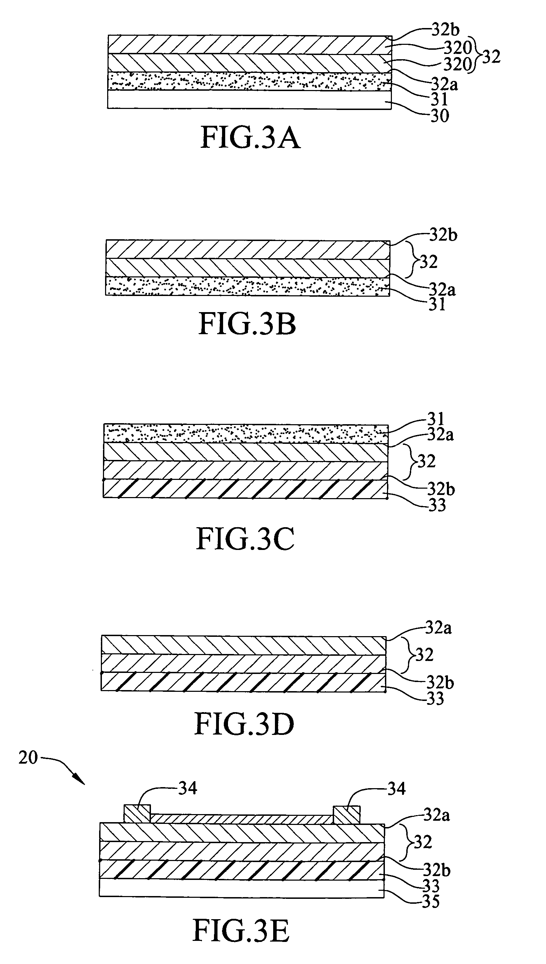

FIGs. 3A to 3E illustrate a process of fabricating the solar cell 20.

Referring to FIG 3A, a substrate 30 having a sacrificial layer (or buffer layer) 31 disposed thereon is provided. An active layer unit 32 is formed on the sacrificial layer 31. The active layer unit 32 has a first surface 32a attached to the sacrificial layer 31 and a second surface 32b opposite to the first surface 32a. A backing layer 33 is formed on the second surface 32b. The backing layer 33 may be made of polymer such as Kapton, metal, such as Au, Cu, Al, Ti, Pt, Ag, and W, an alloy, or a composite of polymer and metal. The active layer unit 32 has two active layers 320. In another embodiment of the present invention, the active layer unit 32 may have only one or more than two layers. The active layer unit 32 is made of a III-V compound.

Referring to FIG 3B, a lift-off process is performed to remove the substrate 30.

Referring to FIG 3C, the sacrificial layer 31 is removed to expose the first surface 32a of the active layer unit 32. By removing the substrate 30 and the sacrificial layer 31, the present invention reduces the weight and thickness of the overall package.

Referring to FIG 3D, a plurality of electrodes 34 are formed on the first surface 32a of the active layer unit 32.

Referring to FIG 3E, a carrier 35 is mounted on the backing layer 33.

The present invention removes the substrate 30 through the lift-off process so as to obtain a thin-film solar cell 20 with reduced thickness, thereby meeting the low-profiled and compact-sized requirements.

The present invention further provides a solar cell package 2, which has a solar cell 20 having a first side 20a and a second side 20b opposite to the first side 20a, first and second insulating layers 21a and 21b formed on the first and second sides 20a and 20b of the solar cell 20, respectively, a light-transmitting layer 22 such as an FEP layer formed on the first insulating layer 21 a, and a protection layer 23 such as a TPT layer formed on the second insulating layer 21b.

The solar cell 20 is a III-V solar cell, and has an active layer unit 32 made of a III-V compound and having a first surface 32a and a second surface 32b opposite to the firsts surface 32a, a plurality of electrodes 34 formed on the first surface 32a of the active layer unit 32, and a backing layer 33 formed on the second surface 32b of the active layer unit 32.

In an embodiment, a carrier 35 is further disposed on the backing layer 33 such that the backing layer 33 is sandwiched between the active layer unit 32 and the carrier 35.

In another embodiment, a plurality of solar cells 20' are provided and electrically connected in series or in parallel.

Therefore, the present invention laminates an EVA layer and an FEP layer on a first side of a solar cell and laminates an EVA layer and an TPT layer on a second side of the solar cell, such that the package has a flexible characteristic since the EVA layer, the FEP layer and the TPT layer are all flexible. The EVA layer and the FEP layer have high transparency and keep a normal light transmittance after a long term of use, thereby allowing the solar cell to keep a normal conversion efficiency.

Furthermore, by laminating the EVA layer and the FEP layer as well as the EVA layer and the TPT layer on the solar cell, the present invention reduces the weight and thickness of the overall structure so as to achieve the purpose of thinning.

The above-described descriptions of the detailed embodiments are only to illustrate the preferred implementation according to the present invention, and it is not to limit the scope of the present invention. Accordingly, all modifications and variations completed by those with ordinary skill in the art should fall within the scope of present invention defined by the appended claims.

## Claims

1. A method of fabricating a III-V solar cell package, comprising:
providing a substrate having a sacrificial layer formed thereon;
forming an active layer unit on the sacrificial layer, wherein the active layer unit is made of a III-V compound and has a first surface attached to the sacrificial layer and a second surface opposite to the first surface, the second surface further having a backing layer formed thereon;
removing the substrate;
removing the sacrificial layer to expose the first surface of the active layer unit;
forming a plurality of electrodes on the first surface of the active layer unit and forming a carrier on the backing layer, thereby forming a solar cell having a first side and a second side opposite to the first side;
forming a first insulating layer on the first side of the solar cell and forming a second insulating layer on the second side of the solar cell;
forming a light-transmitting layer on the first insulating layer and forming a protection layer on the second insulating layer such that the first insulating layer is sandwiched between the solar cell and the light-transmitting layer and the second insulating layer is sandwiched between the solar cell and the protection layer; and
heating and laminating the light-transmitting layer and the protection layer in a vacuum environment, so as to attach the first insulating layer to the light-transmitting layer and the solar cell and to attach the second insulating layer to the protection layer and the solar cell.

2. The method of claim 1, before the first and second insulating layers are formed, further comprising forming a plurality of solar cells and electrically connecting the solar cells in series.

3. The method of claim 1, before the first and second insulating layers are formed, further comprising forming a plurality of solar cells and electrically connecting the solar cells in parallel.

4. The method of claim 1, wherein the light-transmitting layer is made of fluorinated ethylene propylene (FEP) or glass.

5. The method of claim 1, wherein the light-transmitting layer is made of a flexible material.

6. The method of claim 1, wherein the light-transmitting layer is made of a non-flexible material.

7. The method of claim 1, wherein the first and second insulating layers are made of ethylene-vinyl acetate (EVA) or an epoxy material.

8. A III-V solar cell package, comprising:
a solar cell having a first side and a second side opposite to the first side, wherein the solar cell comprises:
an active layer unit made of a III-V compound and having a first surface and a second surface opposite to the first surface;
a plurality of electrodes formed on the first surface of the active layer unit; and
a backing layer formed on the second surface of the active layer unit;
a first insulating layer formed on the first side of the solar cell;
a second insulating layer formed on the second side of the solar cell;
a light-transmitting layer formed on the first insulating layer such that the first insulating layer is sandwiched between the solar cell and the light-transmitting layer; and
a protection layer formed on the second insulating layer such that the second insulating layer is sandwiched between the solar cell and the protection layer.

9. The package of claim 8, further comprising a plurality of solar cells electrically connected in series, and/or
comprising a plurality of solar cells electrically connected in parallel.

10. The package of claim 8, wherein the light-transmitting layer is made of FEP or glass.

11. The package of claim 8, wherein the light-transmitting layer is made of a flexible material.

12. The package of claim 8, wherein the light-transmitting layer is made of a non-flexible material.

13. The package of claim 8, wherein the first and second insulating layers are made of EVA or an epoxy material.

14. The package of claim 8, wherein the protection layer is made of a light-transmitting material or
of a light-reflecting material.

15. The method of claim 8, wherein the protection layer is made of poly vinyl fluoride (PVF), Tedlar/Polyester/Tedlar (TPT) or glass.
